Europäisches Patentamt

European Patent Office

Office européen des brevets

(19)

(11) Publication number:

**0 240 682**

**A2**

(12) **EUROPEAN PATENT APPLICATION**

(21) Application number: **87102616.7**

(22) Date of filing: **24.02.87**

(51) Int. Cl.³: **G 11 C 27/02**
**H 03 H 7/30**

(30) Priority: **24.02.86 JP 37333/86**

(43) Date of publication of application:
**14.10.87 Bulletin 87/42**

(84) Designated Contracting States:
**AT DE FR GB NL**

(71) Applicant: **SONY CORPORATION**
**7-35 Kitashinagawa 6-Chome Shinagawa-ku**
**Tokyo 141(JP)**

(72) Inventor: **Narabu, Tadakuni c/o Sony Corporation**
**7-35, Kitashinagawa 6-chome**
**Shinagawa-ku Tokyo(JP)**

(72) Inventor: **Maki, Yasuhito c/o Sony Corporation**
**7-35, Kitashinagawa 6-chome**
**Shinagawa-ku Tokyo(JP)**

(74) Representative: **Schmidt-Evers, Jürgen, Dipl.-Ing. et al,**
**Patentanwälte Dipl.-Ing. H. Mitscherlich Dipl.-Ing. K.**
**Gunschmann Dipl.-Ing. Dr.rer.nat. W. Körber Dipl.-Ing. J.**
**Schmidt-Evers Dipl.-Ing. W. Melzer Steinsdorfstrasse 10**
**D-8000 München 22(DE)**

(54) **Sample holding circuit.**

(57) A sample holding circuit applicable as an output circuit for CCD (charge coupled device) or other delay line. The sample holding circuit includes a sample holding stage (11, 12) and at least one amplifier circuit (14, 15) connected to the input and/or output of the sample holding stage (11, 12). The amplifier circuit (14, 15) is arranged to amplify a signal at a gain substantially equal to 1 without introducing any DC level shift.

*FIG. 1*

# SAMPLE HOLDING CIRCUIT

## BACKGROUND OF THE INVENTION

This invention relates to a sample holding circuit operable as an output circuit for charge coupled devices or other delay line.

Charge coupled devices or other delay line require sample holding circuits. In such conventional sample holding circuits however, a serious problem occurs in that the signal DC level shifts with respect to the power source or ground potential. This leads to the requirement for complicated circuit designs and an inability to widen dynamic range and operation margin of the circuit. In addition, the conventional sample holding circuit cannot operate reliably on a low voltage and incompatible with the recent tendency toward power source size reduction. Thus, there has been a demand for a practical approach which solves the problems associated with DC level shift introduction.

## SUMMARY OF THE INVENTION

It is a main object of the invention to provide an improved sample holding circuit which can operate without causing any DC level shift.

Another object of the invention is to provide an improved sample holding circuit which can operate reliably on a low voltage.

There is provided, in accordance with the invention, a sample holding circuit comprising a signal source for generating a series of timing pulses, and a sample holding stage having an input for receipt of a voltage signal. The sample holding stage includes a capacitor and a switching transistor responsive to each of the timing pulses for communicating the voltage signal to charge the capacitor. The sample holding stage has an output for producing a signal corresponding to the voltage stored in the capacitor. The sample holding circuit also comprises at least one amplifier circuit associated with the sample holding stage. The amplifier circuit is operable to amplify an input signal at a gain substantially equal to 1 without introducing any DC level shift.

## BRIEF DESCRIPTION OF THE DRAWINGS

This invention will be described in greater detail by reference to the following description taken in connection with the accompanying drawings, in which:

Fig. 1 is a schematic block diagram showing one embodiment of a sample holding circuit made in accordance with the invention;

Fig. 2 is a diagram of an analog signal coupled to the input terminal of the sample holding circuit;

Fig. 3 is a diagram of the signal generated at the output terminal of the sample holding circuit;

Fig. 4 is a circuit diagram showing the amplifier circuit of Fig. 1;

Fig. 5 is a circuit diagram showing another form of the amplifier circuit;

Fig. 6 is a circuit diagram showing a prior art sample holding circuit; and

Fig. 7 is a circuit diagram showing another form of the prior art sample holding circuits.

## DETAILED DESCRIPTION OF THE INVENTION

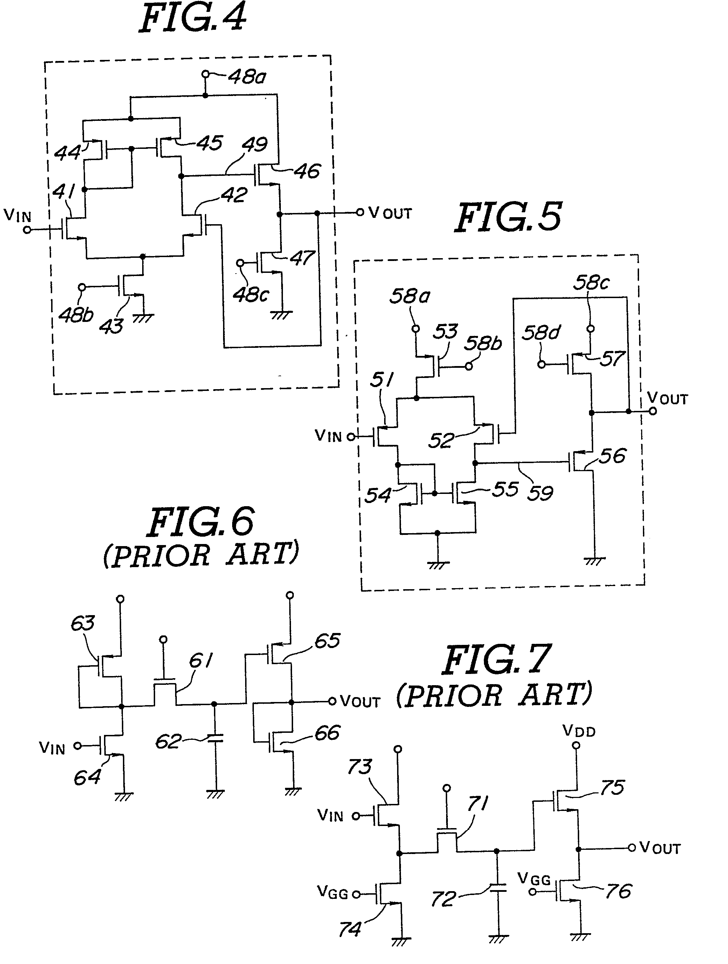

Prior to the description of the preferred embodiment of the invention, the prior art sample holding circuits of Figs. 6 and 7 are briefly described in order to specifically point out the difficulties attendant thereon.

Referring to Fig. 6, the prior art sample holding circuit includes a sample holding stage including a capacitor 62 and a switching transistor 61 operable to communicate a signal to charge the capacitor 62 at appropriate sampling times. The sample holding stage is connected on its input side to an inverter circuit including a pair of MOS transistors 63 and 64 and on its output side to an inverter circuit including a pair of MOS transistors 65 and 66. With such a circuit arrangement, however, a DC level shift is introduced between the transistors 64 and 61 and an additional DC level shift is introduced between the transistors 61 and 65. In addition, gain changes would occur within the circuit.

Referring to Fig. 7, the prior art sample holding circuit includes a sample holding stage including a capacitor 72 and a switching transistor 72 operable to communicate a signal to charge the capacitor 72 at appropriate sampling times. The sample holding stage is connected on its input side to a pair of NMOS transistors 73 and 74 to provide source-follower operation and on its output side to a pair of NMOS transistors 75 and 76 to provide source-follower operation. With such a circuit arrangement, however, a DC level shift is introduced in the MOS transistors 73 and 75. In addition, each of the NMOS transistor pairs have a gain in the order of 0.9 so that the total gain is limited to about 0.81.

Therefore, such prior art sample holding circuits require complicated circuit designs and suffer an inability to widen the dynamic range and operation margin. In addition, they cannot ensure reliable operation under great DC level fluctuations particularly when required to operate on a low-voltage power source.

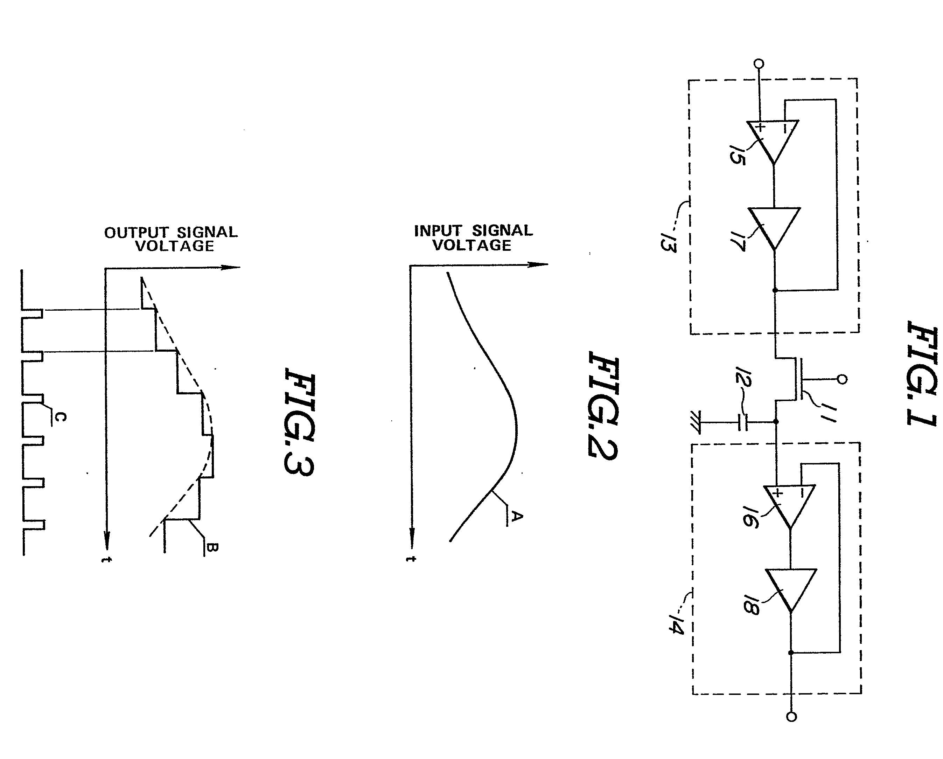

Referring to Fig. 1, there is illustrated a sample holding circuit embodying the invention. While the invention will be described in conjunction with a CCD (charge coupled device) output circuit, it will be appreciated that the invention is equally applicable to other sample holding circuits.

The sample holding circuit comprises a sample holding stage including a switching transistor 11 and a capacitor 12. The switching transistor 11 has one electrode connected to a point which corresponds to the input of the sample holding stage and another electrode connected to one terminal of the capacitor 12, the other terminal of which is connected to ground. The junction between the switching transistor 11 and the capacitor 12 is connected to a point which corresponds to the output of the sample holding stage. The switching transistor 11 also has a gate electrode connected to a signal source (not shown) which generates a series of timing pulses to trigger the switching transistor 11 into the conduction state at appropriate sampling times. Conduction of the switching transistor communicates a voltage signal to charge the capacitor 12.

The sample holding stage is shown as connected at its input and output to voltage-follower circuits 13 and 14, respectively. The voltage-follower circuit 13 includes an operational amplifier 15 and a buffer circuit 17. The operational amplifier 15 has positive and negative inputs. The operational amplifier positive input is connected to an input terminal for connection to a CCD (charge coupled device). The buffer circuit 17 is connected at its input to the output of the operational amplifier 15. The output of the buffer circuit 17 is connected to the input of the sample holding stage and also through a negative feedback path to the negative input of the operational amplifier 15. The operational amplifier 15 is arranged to provide voltage-follower operation amplifying the difference between the signals applied to the positive and negative inputs thereof at a gain substantially equal to 1 with introducing no DC level shift. Since the voltage-follower circuit 13 has a high input impedance and a low output impedance, there is no mutual influence between the circuits. The buffer circuit 17 serves the function pulse signal is indicated by the waveform C of Fig. 3. The sampled signal, which is indicated by the waveform B of Fig. 3, is applied from the sample holding stage to the voltage-follower circuit 14. The voltage-follower circuit 14 amplifies the sampled signal at a gain of 1. Since the voltage-follower circuit 14 introduces no DC level shift, the outputted signal has no DC voltage fluctuation. The output signal is applied from the sample holding circuit output terminal to the following stage.

The detailed circuit arrangement of the voltage-follower circuits 13 and 14, which are substantially the same in circuit arrangement, will be described with reference to Figs. 4 and 5.

Referring to Fig. 4, the operational amplifier 15 or 16 includes a pair of NMOS transistors 41 and 42 connected in common source. Each of the NMOS transistors 41 and 42 has an emitter connected to ground through the collector-emitter circuit of a transistor 43 which has a gate electrode connected to a constant voltage source 48b. The transistor 43 serves as a constant curent source. The transistor 41 has a gate electrode connected to an input terminal vin. The NMOS transistor pair is connected to a constant voltage source 48a through an active load which includes a pair of transistors 44 and 45 each having an emitter connected to the constant voltage source 48a and a base connected to the collector of the transistor 41. The transistor 44 has a collector connected to the collector of the transistor 41. The transistor 45 has a collector connected to the collector of the transistor 42. The junction between the transistors 45 and 42 forms an operational amplifier output terminal.

The buffer circuit 17 or 18 includes a pair of NMOS transistors 46 and 47. The transistor 46 has a base connected to the operational amplifier output of increasing the input impedance and reducing the output impedance.

Similarly, the voltage-follower circuit 14 includes an operational amplifier 16 and a buffer circuit 18. The operational amplifier 16 has positive and negative inputs. The operational amplifier positive input is connected to the output of the sample holding stage. The buffer circuit 18 is connected at its input to the output of the operational amplifier 16. The output of the buffer circuit 18 is connected to an output terminal for connection to another stage. The buffer circuit output is also connected through a negative feedback path to the negative input of the operational amplifier 16. The operational amplifier 16 is arranged to provide a voltage-follower operation amplifying the difference between the signals applied to the positive and negative inputs thereof at a gain substantially equal to 1 without introducing any DC level shift. Since the voltage-follower circuit 14 has a high input impedance and a low output impedance, there is no mutual influence between the circuits. The buffer circuit 18 serves the function of increasing the input impedance and reducing the output impedance.

The operation is as follows. It is now assumed that an analog signal, as indicated by the waveform A of Fig. 2, is applied to the input terminal of the sample holding circuit. The analog signal is applied to the voltage-follower circuit 13 which amplifies the analog signal at a gain of 1 and applies the amplified analog signal to the sample holding state. Since the voltage-follower circuit 14 introduces no DC level shift, the amplified signal has no DC level fluctuation. The sample holding stage samples and holds values for the analog signal at appropriate sampling times determined by the timing pulse signal applied to the switching transistor gate electrode. The timing terminal; that is, the junction between the transistors 45 and 42. The transistor 46 also has a collector connected to the constant voltage source 48a and an emitter connected to the collector of the transistor 47. The transistor 47 has a gate electrode connected to a constant voltage source 48c and an emitter connected to ground. The junction between the transistors 46 and 47 is connected to an output terminal vout and also through a negative feedback path to the gate electrode of the transistor 42.

Referring to Fig. 5, the operational amplifier 15 or 16 includes a pair of PMOS transistors 51 and 52 connected in a common source fashion. Each of the PMOS transistors 51 and 52 has an emitter connected to a constant voltage source 58a through the collector-emitter circuit of a transistor 53 which has a gate electrode connected to a constant voltage source 58b. The transistor 53 serves as a constant current source. The transistor 51 has a gate electrode connected to an input terminal Vin. The PMOS transistor pair is connected to ground through an active load which includes a pair of transistors 54 and 55 each having an emitter connected to ground and a base connected to the collector of the transistor 51. The transistor 54 has a collector connected to the collector of the transistor 51. The transistor 55 has a collector connected to the collector of the transistor 52. The junction between the transistors 55 and 52 forms an operatonal amplifier output terminal.

The buffer circuit 17 or 18 includes a pair of PMOS transistors 66 and 57. The transistor 56 has a base connected to the operational amplifier output terminal; that is, the junction between the transistors 55 and 52. The transistor 56 also has a collector connected to ground and an emitter connected to the collector of the transistor 57. The transistor 57 has a

gate electrode connected to a constant voltage source 58d and an emitter connected to a constant voltage source 58c. The junction between the transistors 56 and 57 is connected to an output terminal Vout and also through a negative feedback path to the gate electrode of the transistor 52.

It is apparent from the foregoing that there is provided, in accordance with the invention, a sample holding circuit which can operate without introducing any DC level shift. This feature is effective to simplify circuit design. The sample holding circuit can be arranged to have a wider dynamic signal range and a wider circuit margin so that the circuit can operate on a low-voltage power source. In addition, a plurality of such sample holding circuits can be connected to form a multistage sample holding circuit which can operate without any voltage shift associated problems.

While two amplifier circuits have been shown and described as being connected on the input and output sides of a sample holding stage, it will be appreciated that the sample holding circuit may includes at least one amplifier circuit connected to the input and/or output side of the sample holding stage.

Although this invention has been described in conjunction with a specific embodiment thereof, it is evident that many alternatives, modifications and variations will be apparent to those skilled in the art. Accordingly, it is intended to embrace all alternatives, modifications and variations that fall within the scope of the appended claims.

## C L A I M S

1. A sample holding circuit, characterized in:
a signal source for generating a series of timing pulses;
a sample holding stage (11, 12) having an input for receipt
of a voltage signal, the sample holding stage including
a capacitor (12) and a switching transistor (11) responsive
to each of the timing pulses for communicating the voltage
signal to charge the capacitor (12), the sample holding
stage (11, 12) having an output for producing a signal
corresponding to the voltage stored in the capacitor;
and
at least one amplifier circuit (13, 14) associated with
the sample holding stage (11, 12), the amplifier circuit
(13, 14) being operable to amplify an input signal at
a gain substantially equal to 1 without introducing any
DC level shift.

2. The sample holding circuit as claimed in claim 1,
characterized in that the amplifier circuit includes
a voltage-follower circuit (13, 14) comprising:
an operational amplifier (15,16) having two inputs for
receipt of two signals for amplifying a difference between
the two signals, the operational amplifier (15, 16) having
an output for producing a signal corresponding to the
difference, the operational amplifier (15, 16) including
a pair of transistors (41, 42; 51, 52) connected to provide
voltage-follower operation; and
a buffer circuit (17, 18) having an input connected to
the output of the operational amplifier (15, 16), the
buffer circuit (17, 18) having an output coupled through
a negative feedback path to one of the two inputs of
the operational amplifier (15, 16).

3. The sample holding circuit as claimed in claim 2, characterized in that the operational amplifier (15, 16) includes a pair of NMOS transistors (41, 42) each having an emitter connected through a constant current source (43, 48b) to ground and a collector connected through an active load (44, 45) to a constant voltage source (48a).

4. The sample holding circuit as claimed in claim 2, characterized in that the operational amplifier (15, 16) includes a pair of PMOS transistors (51, 52) each having an emitter connected through a constant current source (53, 58b) to a constant voltage source (58a) and a collector connected through an active load (54, 55) to ground.

5. The sample holding circuit as claimed in any one of claims 1 to 4, characterized in that the sample holding circuit has an input coupled to a delay line.

6. The sample holding circuit as claimed in any one of claims 1 to 5, characterized in that the sample holding circuit has an input coupled to a charge coupled device.

7. The sample holding circuit as claimed in any one of claims 1 to 6, characterized in that the amplifier circuit (13) is connected to the input of the sample holding stage (11, 12).

8. The sample holding circuit als claimed in any one of claims 1 to 6, characterized in that the amplifier circuit (14) is connected to the output of the sample holding stage (11, 12).

9. The sample holding circuit as claimed in any one of claims 1 to 6, characterized in that it includes first and second amplifier circuits (14, 15), the first amplifier circuit (14) being connected to the input of the sample holding stage (11, 12), the second amplifier circuit (15) being connected to the output of the sample holding stage (11, 12), each of the first and second amplifier circuits (14, 15) being operable to amplify an input signal at a gain substantially equal to 1 without introducing any DC level shift.

# FIG. 1

# FIG. 2

# FIG. 3

## FIG.4

## FIG.5

## FIG.6
### (PRIOR ART)

## FIG.7
### (PRIOR ART)